# EUROPEAN PATENT APPLICATION

(11) **EP 4 297 087 A1**
(43) Date of publication of application: **27.12.2023**
(21) Application number: 22181020.3
(22) Date of filing: 24.06.2022
(51) Int. Cl.: H01L 25/07, H01L 23/538, H02M 7/00

(54) **POWER ELECTRONIC MODULE WITH PARALLELY CONNECTED POWER ELECTRONIC DEVICES**

(71) Applicant: Airbus S.A.S., 31700 Blangnac (FR)
(72) Inventor: KAPAUN, Florian, 82024 Taufkirchen (DE); STEINER, Gerhard, 82024 Taufkirchen (DE)
(74) Representative: OTN Airbus SAS

(57) **Abstract**

A power electronic module is proposed, comprising at least one substrate, a plurality of power electronic devices arranged on the at least one substrate, a common signal port, and at least two electrical conductors connected to the power electronic devices, wherein each of the power electronic devices comprises a signal input, wherein each of the power electronic devices comprises a signal input connected to the common signal port through signal lines, wherein the power electronic devices are positioned on the at least one substrate in a way that the distances of each of the signal inputs of the power electronic devices to the signal port are equal.

## Description

### Technical field

The invention relates to a power electronic module, an electric inverter circuit and a vehicle having at least one electrical consumer and at least one electric inverter circuit.

### Background of the invention

In common power electronic inverters, or power modules, the amount of internally paralleled semiconductors for increasing the current capability of the module is limited. This is mainly due to gate signal restrictions, increase of internal parasitic inductances and challenge of equal current sharing between all semiconductors. Standard power modules often comprise a rectangular shape with electric connections in a center region or on one side of the power module, so that distance to the left and right semiconductors is more or less equal. As the distance is growing with additional paralleled semiconductors, this becomes a limiting factor. Large distances lead to an additional loop inductance and also longer signal runtime. Switching command signals to the semiconductors that are conducted along different distances leads to different time delays in switching and therefore to unsymmetric stress of the single paralleled semiconductors.

Additional stray inductance limits the switching time and decreases efficiency of the power module. Additionally, the current distribution among all the semiconductors will not stay equal. Especially for fast switching devices like Wide Bandgap semiconductors these effects drastically influence the performance.

### Summary of the invention

It is thus an object of the invention to propose a power electronic module with parallel power electronic devices with an improved efficiency and symmetric stress of all semiconductors.

This object is met by a power electronic module having the features of claim 1. Advantageous embodiments and further improvements may be gathered from the subclaims and the following description.

A power electronic module is proposed, comprising at least one substrate, a plurality of power electronic devices arranged on the at least one substrate, a common signal port, and at least two electrical conductors connected to the power electronic devices, wherein each of the power electronic devices comprises a signal input, wherein each of the power electronic devices comprises a signal input connected to the common signal port through signal lines, wherein the power electronic devices are positioned on the at least one substrate in a way that the distances of each of the signal inputs of the power electronic devices to the signal port are equal.

The at least one substrate may exemplarily be a common PCB substrate. It is important that the at least one substrate is dimensionally sufficiently stable to provide a suitable base for the power electronic module and maintain the positions of the individual components thereof.

The power electronic module comprises an electric circuit that is mainly adapted for providing an alternating current (AC) for an electric machine from a DC source. For this, a plurality of power electronic devices is used, which may form a plurality of half bridges. These may be designed according to commonly known half bridges.

A half bridge may be associated to a gate driver and comprises a pair of a first switching unit and a second switching unit, which may exemplarily be realized in the form of field effect transistors (FETs). The first switching unit may be considered a "high side" switching unit, while the second switching unit may be considered a "low side" switching unit. A plurality of parallel power electronic devices, i.e. a plurality of parallel pairs of half bridges, allows to increase the current delivered by the power electronic module.

A gate driver or a similar device is provided for initiating the switching action of the first and second switches of all pairs to selectively couple the DC voltage source or a reference voltage, such as the ground voltage, to the voltage output. By using a certain switching pattern, the characteristics of the generated modulated, i.e. alternating, current is influenced.

For controlling the individual power electronic devices, i.e. the first switching units and the second switching units, the gate driver is in a signal connection to the common signal port, which in turn is connected with the signal inputs of all power electronic devices. When the gate driver sends a switching signal to the common signal port of the power electronic module, the switching signal is transferred to all switching units simultaneously. For example, the switching signals may be based on a PWM signal or similar.

By placing the power electronic devices on the at least one substrate in a way that the distances of each of the signal inputs of the power electronic devices to the signal port are equal, the switching signal is received in the individual switching units at the same time. Thus, the electric current delivery is distributed over all power electronic devices equally. The proposed design also has an improved connection to the respective semiconductors in terms of power transfer through a decrease of commutation loop inductance. Hence, the module can carry much more paralleled power electronic devices and therefore increases the current capability. This leads to higher currents at lower weight and volume and therefore increases the overall system efficiency.

In an advantageous embodiment, the power electronic devices are distributed along a circular or regularly polygonal path of the at least one substrate. Thus, the power electronic devices are geometrically arranged on the at least one substrate so that equal signal transfer lengths can be guaranteed. The shape of the polygonal path may depend on the number of power electronic devices. For example, if four power electronic devices are used, the polygonal path may be a square; if five power electronic devices are used, the polygonal path may be pentagon, and so on. On a circle, the individual power electronic devices may be placed with equal distances to each other to positively influence the stray inductance behavior.

The at least one substrate may comprise one, two or more layers, wherein the at least two electrical conductors are arranged on different layers. Both conductors may then be designed in the same way and an electrical contact between both can be avoided.

In an advantageous embodiment, the plurality of power electronic devices comprises at least three, four, five, six, seven, eight, nine, ten or more power electronic devices. By increasing the number of power electronic devices, the current can be increased to an amount needed for the respective application.

In an advantageous embodiment, the power electronic devices are symmetrically arranged on a common plane of the at least one substrate. This simplifies the connection between the power electronic devices and the common signal port as well as the two conductors.

In an advantageous embodiment, the power electronic devices comprise Wide Band Gap (WBG) semiconductors.

In an advantageous embodiment, the at least two conductors comprise the shape of a circular ring. This shape is beneficial for surrounding and contacting an arbitrary number of power electronic devices that are arranged on a circular or polygonal path. The conductors have a minimum diameter and a maximum diameter, which define a width of the conductor, which in turn may be selected according to the intended current.

In an advantageous embodiment, a maximum diameter of a first conductor is smaller than a minimum diameter of a second conductor, wherein the conductors are arranged concentrically on the at least one substrate surrounding the power electronic devices. Thus, the first conductor is surrounded by the second conductor, wherein a gap is arranged between both conductors to prevent a contact between both.

In an advantageous embodiment, the signal lines extend from one surface to another surface of the at least one substrate to avoid contact with one of the conductors. A power electronic device may thus be connected to a respective signal line on one of the surfaces. The signal line extends in thickness direction through the at least one substrate to the other, opposite surface. On the other surface, the signal line extends along the respective other surface towards the common signal port. Afterwards, it extends in thickness direction through the at least one substrate again to contact the common signal port. However, other variants are possible, e.g. with the common signal port arranged on the other surface without the need for extending in thickness direction twice.

In an advantageous embodiment, the power electronic devices surround a center of the at least one substrate, wherein the common signal port is arranged in the center of the at least one substrate. The position of the common signal port is thus beneficial for simply contacting an arbitrary number of power electronic devices. Furthermore, the power electronic module may thus be designed to be completely symmetrical.

In an advantageous embodiment, the power electronic module comprises two sets of power electronic devices arranged on two opposite sides of the at least one substrate, wherein the two sets of power electronic devices are interconnected to form a half bridge or a full bridge for an electric inverter circuit. While a half bridge circuit requires two switching units, i.e. power electronic devices for each phase, a full bridge circuit requires four switching units.

The invention further relates to an electric inverter circuit, comprising a plurality of power electronic modules according to the above description, wherein the power electronic modules constitute an inverter, in particular an inverter having a plurality of half-bridges and/or a plurality of full-bridges.

In an advantageous embodiment, a part of the plurality of power electronic modules of each half bridge or each full bridge is placed on a top surface of the at least one substrate, wherein another part of the plurality of power electronic modules of each half bridge or each full bridge is placed on a bottom surface of the at least one substrate.

The invention further relates to a vehicle comprising an electric consumer and at least one electric inverter circuit according to the above.

In an advantageous embodiment, the vehicle is an aircraft.

### Brief description of the figures

In the following, the attached drawings are used to illustrate exemplary embodiments in more detail. The illustrations are schematic and not to scale. Identical reference numerals refer to identical or similar elements. They show:
Fig. 1a shows a schematic illustration of a power electronic module with four power electronic devices.
Fig. 1b shows a power electronic device.
Fig. 2 shows another schematic illustration of a power electronic module with eight power electronic devices.
Fig. 3 shows a schematic illustration of a power inverter circuit.
Fig. 4a and 4b show different contacting arrangements for contacting power electronic devices.
Fig. 5 shows an aircraft having an electrical consumer and a power inverter circuit.

### Detailed description of exemplary embodiments

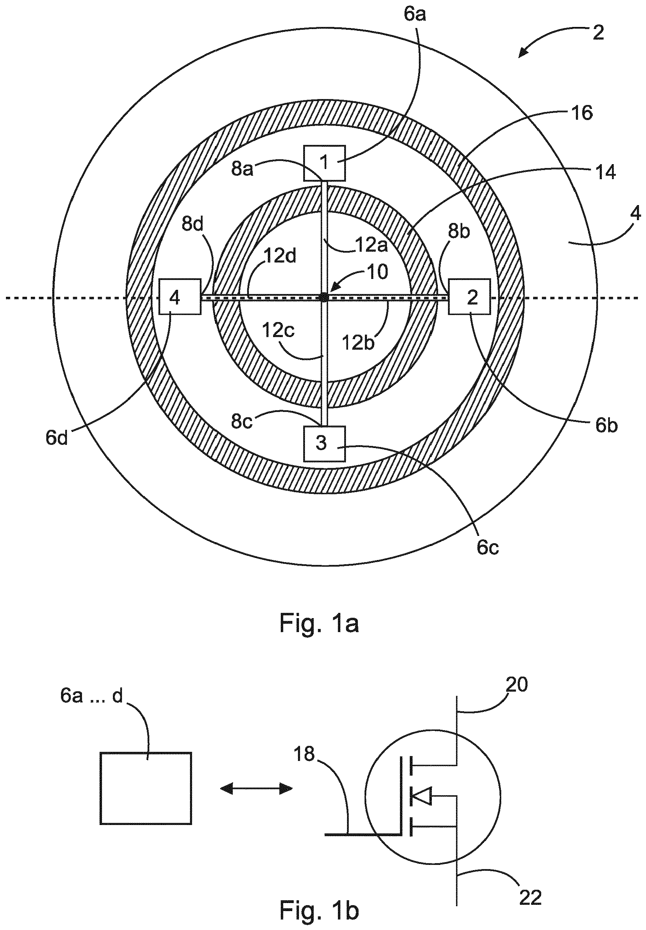

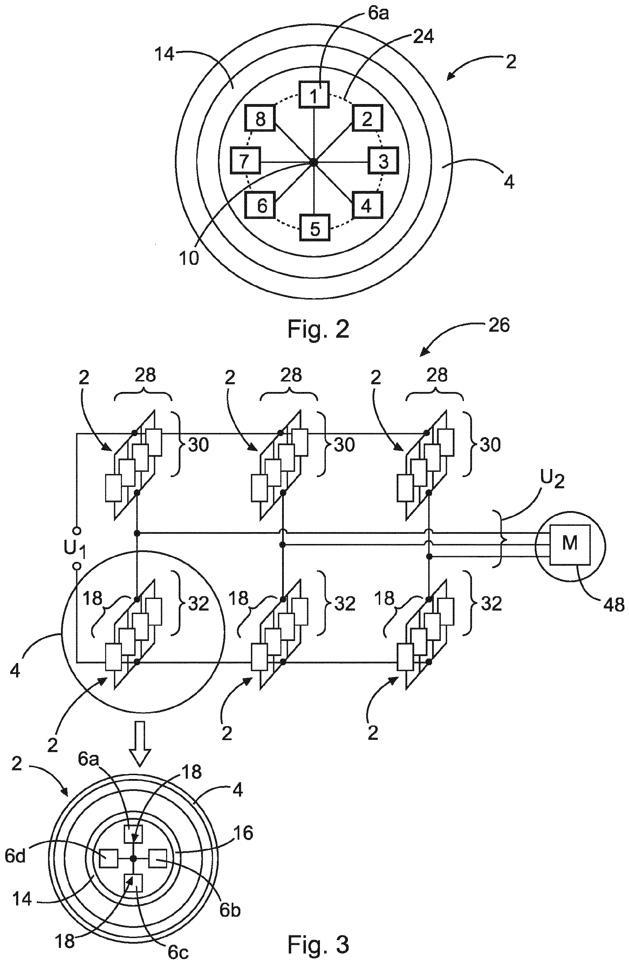

Fig. 1a shows a power electronic module 2 comprising a substrate 4 and a plurality of power electronic devices 6A, 6B, C and 6D arranged on the substrate 4. The power electronic devices 6a-6d are provided in the form of a semiconductor switch, such as field-effect transistor switches, e.g. n-MOSFETs, JFETs or p-MOSFETs. However, they may also comprise IGBTs and WBG semiconductors. They are used in an inverter circuit (see Fig. 3) for generating a modulated, i.e. alternating, voltage at a voltage output for supplying an electric consumer. The power electronic devices 6a-6d are controlled by a gate driver or similar device to alternately switch a phase terminal of the respective voltage output against a source voltage or ground. For receiving a signal of the gate driver or similar device, each of the plurality of power electronic devices 6a-6d comprises a signal input 8a, 8b, 8c and 8d, which are connected to a common signal port 10 through individual signal lines 12a, 12b, 12c and 12d.

In this exemplary embodiment, the substrate 4 has a circular shape and the power electronic devices 6a-6d are arranged on a circular line on the substrate 4. The common signal port 10 is arranged in the center of the substrate 4, wherein the distances to each of the power electronic devices 6a-6d and thus, the lengths of the signal lines 12a to 12d, are equal. A signal delivered to the common signal port 10 is transferred to all power electronic devices 6a-6d simultaneously. Hence, they are able to switch simultaneously and they will be equally stressed.

Furthermore, the power electronic module 2 comprises two electrical conductors 14 and 16, which are exemplarily provided in a circular form. Each of the power electronic devices 6a-6d is coupled to both conductors 14 and 16 to deliver electrical current. By providing the circular form of the conductors 14 and 16, the distances to the individual power electronic devices 6a-6d are equal, and substantially any arbitrary number of power electronic devices can be contacted easily.

The conductors 14 and 16 may be arranged in different layers of the substrate 4, on its top side and bottom side or on the same layer. In this exemplary embodiment, they are provided on the same layer and comprise different diameters. If the power electronic devices 6a-6d are realized as FET, they each comprise three terminals for controlling the flow of current, i.e. the drain, source, and gate terminals. The drain-source path carries the load current. The gate terminal controls the conductivity between the source terminal and the drain terminal. As the power electronic devices 6a-6d provide a parallel connection, all drain terminals and all source terminals of a single power module 2 are connected to the same conductor 14 or 16. For example, the inner conductor 14 with the smallest diameter, is used for connecting all source terminals and may thus be referred to as a source ring 14. The conductor 16, which is exemplarily connected to all drain terminals may thus be referred to as drain ring 16.

The power electronic devices 6a-6d are arranged symmetrically and equidistant on the substrate 4. Thus, the signal lines 12a-12d enclose right angles to each other in this example. If further power electronic devices are to be integrated, the total arrangement is to be adjusted accordingly.

Fig. 1b shows an electrical symbol of the power electronic devices 6a-6d. Here, a field effect transistor is shown, which is exemplarily an N-channel MOSFET transistor. Here, a gate terminal 18, a drain terminal 20 and a source terminal 22 are shown. The source terminal 22 is connected to the source ring 14, while the drain terminal 20 is connected to the drain ring 16 of the respective power module 2. The gate terminal 18 is connected to the common signal input 10 through one of the signal lines 12a to 12d and may thus be referred to as a signal input 18.

Fig. 2 shows a further example of a power electronic module 2 with a total number of eight power electronic devices 6a-6h, which are distributed on a circular path 24 on the substrate 4 in a symmetrical manner. Signal lines 12a to 12h are connected to the common signal port 10, wherein the signal lines 12a to 12h are straight and enclose angles of 45° to each other. Exemplarily, the source ring 14 is arranged on the visible surface of the substrate 4 shown in this drawing, while the drain ring 16 may be arranged on the opposite surface, i.e. underneath the source ring 14, such that the substrate 4 is sandwiched between the source ring 14 and the drain ring 16.

Fig. 3 shows an inverter circuit 26 in an exemplary embodiment. Here, three half bridges 28 are shown, which provide an alternating current with three phases with a voltage U₂ for an electric consumer 48. All half bridges 28 are supplied with a direct current with a voltage U₁. Each of the half bridges 28 comprises a high side 30 and a low side 32. Each of the high sides 30 and low sides 32 of the half bridges 28 exemplarily comprises a plurality of parallel power electronic devices 6a-6d, which are provided in the form of a power module 2 to benefit from the advantages according to the above. Hence, a power module 2 may constitute a high side 30 or a low side 32 of the inverter circuit 26.

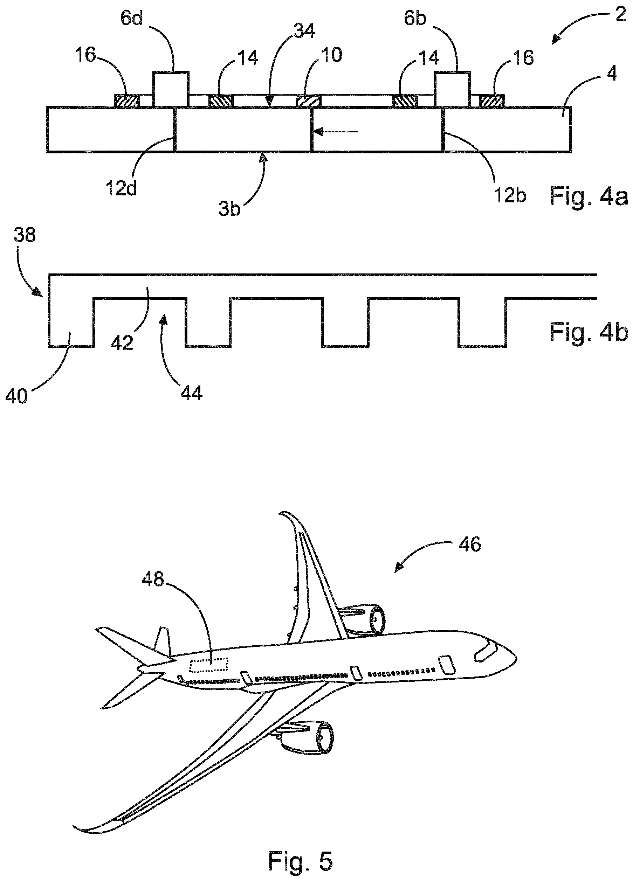

Fig. 4a shows a cross-sectional view of a power electronic module 2 perpendicular to its main extension plane. In this view, only the second and the fourth power electronic devices 6b, 6d are visible. They are attached to a top surface 34 of the substrate 4. The common signal port 10 is connected to the signal inputs 8b and 8d of the power electronic devices 6b and 6d through signal lines 12b, 12d, which extend through the substrate 4 from the top surface 34 to a bottom surface 36 along a thickness direction of the substrate 4. They extend along the bottom surface 36 underneath the power electronic devices 6b and 6d and through the substrate 4 again to connect to the power electronic devices 6b and 6d.

Fig. 4b shows an alternative design for connecting the source terminals 22 and drain terminals 20 in the form of a comb element 38, which comprises a plurality of connecting sections 40 and intermediate sections 42 extending between the connecting sections 40. The connecting sections 40 thus enclose intermediate spaces 44 between each other, through which the signal lines 12a to 12d may be routed. The connecting sections 40 may directly connect the source terminals 22 or the drain terminals 20.

Fig. 5 shows an aircraft 46, which comprises at least one electric consumer 48, such as an electric machine, which is indicated by a box having dashed lines. It may be any kind of electric consumer and in particular any inductive load. The electric consumer 48 is connected to an inverter circuit 26, which in turn is connected to a voltage source, in particular a high DC voltage source.

### Reference numerals

- 2: power electronic module
- 4: substrate
- 6: power electronic device
- 8: signal input
- 10: common signal port
- 12: signal line
- 14: conductor / source ring
- 16: conductor / drain ring
- 18: gate terminal
- 20: drain terminal
- 22: source terminal
- 24: circular path
- 26: inverter circuit
- 28: half bridge
- 30: high side
- 32: low side
- 34: top surface
- 36: bottom surface
- 38: comb element
- 40: connecting section
- 42: intermediate section 42
- 44: intermediate space
- 46: aircraft
- 48: electric consumer

## Claims

1. Power electronic module (2), comprising:
at least one substrate (4),
a plurality of power electronic devices (6) arranged on the at least one substrate (4),
a common signal port (10), and
at least two electrical conductors (14, 16) connected to the power electronic devices (6),
wherein each of the power electronic devices (6) comprises a signal input (18) connected to the common signal port (10) through signal lines (12),
wherein the power electronic devices (6) are positioned on the at least one substrate (4) in a way that the distances of each of the signal inputs (8) of the power electronic devices (6) to the signal port (10) are equal.

2. Power electronic module (2) according to claim 1,
wherein the power electronic devices (6) are distributed along a circular or regularly polygonal path (24) of the at least one substrate (4).

3. Power electronic module (2) according to any of the preceding claims,
wherein the plurality of power electronic devices (6) comprises at least three, four, five, six, seven, eight, nine, ten or more power electronic devices (6).

4. Power electronic module (2) according to any of the preceding claims,
wherein the power electronic devices (6) are symmetrically arranged on a common plane of the at least one substrate (4).

5. Power electronic module (2) according to any of the preceding claims,
wherein the power electronic devices (6) comprise Wide Band Gap (WBG) semiconductors.

6. Power electronic module (2) according to any of the preceding claims,
wherein the at least two conductors (14, 16) comprise the shape of a circular ring.

7. Power electronic module (2) according to claim 6,
wherein a maximum diameter of a first conductor (14) is smaller than a minimum diameter of a second conductor (16), and
wherein the conductors (14, 16) are arranged concentrically on the at least one substrate (4) surrounding the power electronic devices (6).

8. Power electronic module (2) according to claim 6 or 7,
wherein the signal lines (12) extend from one surface (34, 36) to another surface (34, 36) of the at least one substrate to avoid contact with one of the conductors (14, 16).

9. Power electronic module (2) according to any of the preceding claims,
wherein the power electronic devices (6) surround a center of the at least one substrate (4), and
wherein the common signal port (10) is arranged in the center of the at least one substrate (4).

10. Power electronic module (2) according to any of the preceding claims,
wherein the power electronic module (2) comprises two sets of power electronic devices (6) arranged on two opposite sides of the at least one substrate (4), and
wherein the two sets of power electronic devices (6) are interconnected to form a half bridge or a full bridge for an electric inverter circuit (26).

11. Electric inverter circuit (26), comprising a plurality of power electronic modules (2) according to any of the preceding claims,
wherein the power electronic modules (2) constitute an inverter, in particular an inverter having a plurality of half-bridges and/or a plurality of full-bridges.

12. Electric inverter circuit (26) according to claim 11,
wherein a part of the plurality of power electronic modules (2) of each half bridge or each full bridge is placed on a top surface (34) of the at least one substrate (4) and wherein another part of the plurality of power electronic modules (2) of each half bridge or each full bridge is placed on a bottom surface (36) of the at least one substrate (4).

13. Vehicle (46), comprising an electric consumer (48) and at least one electric inverter circuit (26) according to claim 11 or 12.

14. Vehicle (46) according to claim 13, wherein the vehicle (46) is an aircraft.
